# EUROPÄISCHE PATENTSCHRIFT

(11) **EP 1 771 318 B1**
(45) Veröffentlichungstag und Bekanntmachung des Hinweises auf die Patenterteilung: **24.06.2009**
(21) Anmeldenummer: 05739883.6
(22) Anmeldetag: 29.04.2005
(51) Int. Cl.: B60R 16/02, H05K 5/00, H01R 13/52

(54) **STEUERVORRICHTUNG, INSBESONDERE MECHATRONISCHES GETRIEBE- ODER MOTORSTEUERGERÄT**
CONTROL DEVICE, PARTICULARLY A MECHATRONIC TRANSMISSION CONTROL DEVICE OR ENGINE CONTROL DEVICE
DISPOSITIF DE COMMANDE, NOTAMMENT APPAREIL DE COMMANDE MECATRONIQUE DE TRANSMISSION OU DE MOTEUR

(30) Priorität: 28.07.2004 DE 102004036683
(43) Veröffentlichungstag der Anmeldung: 11.04.2007
(73) Patentinhaber: Continental Automotive GmbH, 30165 Hannover (DE)
(72) Erfinder: LOIBL, Josef, 93077 Bad Abbach (DE); SMIRRA, Karl, 83512 Wasserburg (DE)
(86) Internationale Anmeldenummer: PCT/EP2005/051956
(87) Internationale Veröffentlichungsnummer: WO 2006/010652

(56) Entgegenhaltungen:
- EP-A- 1 239 710
- DE-A1- 10 246 090
- DE-A1- 19 637 626
- DE-C1- 10 100 823
- DE-C1- 19 751 095
- DE-U1- 20 320 315

## Beschreibung

Die vorliegende Erfindung betrifft eine Steuervorrichtung, insbesondere für mechatronische Steuergeräte der Getriebe- oder Motorsteuerung eines Kraftfahrzeuges, nach dem Oberbegriff gemäß Anspruch 1.

Automatikgetriebe für Personenkraftfahrzeuge (PKW), aber auch Verbrennungskraftmaschinen (Motoren) oder Bremssysteme etc., werden zunehmend vornehmlich elektronisch gesteuert. Während dafür bisher sog. "stand-alone"-Steuergeräte zum Verbau in einen vor Umwelteinflüssen schützenden Elektronikraum (E-Box) oder in den Passagierraum vorgesehen waren, setzt sich der Trend zu sog. mechatronischen Steuerungen, also zur Integration von Steuerelektronik und der zugehörigen Sensorik in das Getriebe, den Motor, das Bremssystem oder dergleichen weiter fort. Ähnliche Trends für "Vorortelektronik" gibt es auch in anderen Bereichen außerhalb der Kraftfahrzeugtechnik wie der Luft- und Raumfahrtechnik, der Schiffstechnik, etc.

In einigen Anwendungen mechatronischer Steuerungen werden Stanzgitter zur Strom- und Signalverteilung eingesetzt. Diese Lösung zeigt jedoch deutliche Nachteile bezüglich der Punkte Abdichtung des Elektronikraumes, Spanschutz, Flexibilität und Toleranzausgleich gegenüber einer sog. Flextechnologie. Des weiteren ist wegen Einhaltung von Mindestquerschnitten der Stanzgitter eine Entflechtung der Leiterbahnen schwerer möglich als bei Flex-Leiterbahnen (Ausbildung sehr feiner Strukturen von Cu-Leiterbahnen). Bei Änderungen sind zudem teuere Eingriffe in das Stahzwerkzeug notwendig.

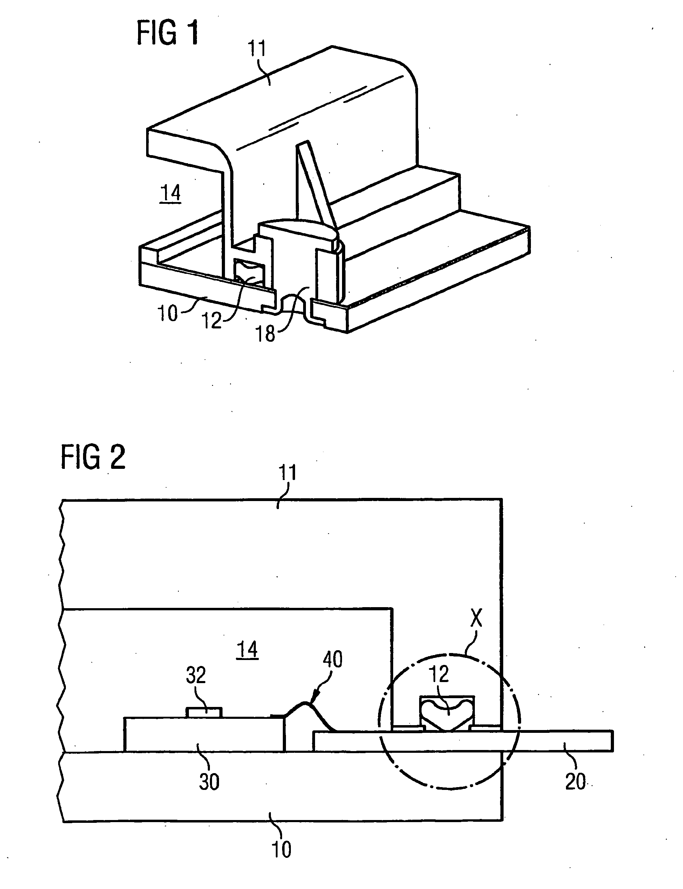

Wie anhand der Fig. 1 bis 5 verdeutlicht, umfassen aktuelle Serienanwendungen, beispielsweise einer mechatronischen Getriebesteuerung, einen Schaltungsträger 30, welcher mit Leiterbahnen 23 wenigstens eines flexiblen Leiterbahnträgers 20 zur Verteilung von elektrischen Signalen und Strömen verbunden ist. Der Schaltungsträger 30 sowie der Leiterbahnträger 20 werden von einer Grundplatte 10 getragen. Der Schaltungsträger 30 ist in einem Hohlraum 14 angeordnet, welcher 14 durch ein Gehäuseteil 11 ausgebildet ist, wobei der Leiterbahnträger 20 zwischen der Grundplatte 10 und dem Gehäuseteil 11 hindurch in den Hohlraum 14 geführt und mit einem flüssigkeitsbeständigen Kleber 22 mit der Grundplatte 10 wenigstens teilweise dergestalt verklebt und mit wenigstens einem Formdichtelement 12 gegenüber dem Gehäuseteil 11 abgedichtet ist, dass keine Flüssigkeit in den Hohlraum 14 eindringen kann.

Fig. 1 zeigt in einer perspektivischen Darstellung den grundsätzlichen Aufbau des Dichtkonzeptes des Elektronikraumes 14 eines Getriebesteuergerätes; Fig. 2 den Aufbau nach Fig. 1 in einer Seitenansicht.

Fig. 3 zeigt den Ausschnitt X aus Fig. 2 in einer vergrößerten Darstellung. Der dargestellte Schichtenaufbau eines flexiblen Leiterbahnträger 20 besteht in der Regel aus einer ersten Basis- 24 und einer zweiten Deckfolie 21 jeweils z.B. aus Polyimid, wobei dazwischen eingebettet sich Leiterbahnen 23 z.B. aus Kupfer (Cu) befinden. Durch Einsatz eines Acryl-Klebers 22 zwischen den Schichten 21 und 24 entsteht eine feste Einheit.

Fig. 4 zeigt das Flex-Layout einer mechatronischen Getriebesteuerung; Fig. 5 den grundsätzlichen Aufbau einer mechatronischen Steuerung bei Verwendung einer einteiligen, einlagigen Flexleiterplatte 20.

Das zuvor beschriebene Dichtkonzept ist beispielsweise aus der US 6,300,566 B1 respektive EP 0 972 318 B1 bekannt, wobei zur Strom- und Signalverteilung aus Kostengründen ausnahmslos einlagige, ölbeständige Flex-Leiterplatten 20 eingesetzt werden. Dieses spezielle Flexmaterial 20 wird gegenwärtig immer einteilig ausgeführt, d.h. die Folie 20 umläuft den Schaltungsträger 30 vollständig, was den Verbrauch großer Flächen teuren Flex-Materials 20 bedeutet. Zudem muss im Innenbereich der Folie 20 für die Elektronik 30 ein rechteckiger Bereich 29 ausgespart werden, der nicht nutzbar ist. Um alle Anschlussbereiche 33, 34 zu erreichen und gleichzeitig den verfügbaren Nutzen optimal auszunutzen, wird eine eigens entwickelte Falttechnik eingesetzt. Trotzdem ist es nicht vermeidbar, dass oftmals ein Verwurf entsteht, da es die Getriebeeinbauräume nicht anders zulassen.

Die DE 197 51 095 C1 beschreibt eine Anordnung zum elektrischen Verbinden einer an einem Gehäuse aufgenommenen elektrischen Baugruppe mit einer außerhalb des Gehäuses angeordnete elektrischen Peripherie über ein elektrisches Verbindungselement. Das elektrische Verbindungselement ist als ein flacher, flexibler Leiterbahnträger mit darin integrierten elektrischen Leiterbahnen ausgebildet und im Bereich einer Gehäusedichtung zwischen zwei Gehäuseteilen in das Gehäuse hineingeführt.

Aus der DE 101 00 823 C1 geht ein dichter Elektronikraum für ein Motor- oder Getriebe-integriertes Steuergerät hervor, das eine Trägerplatte aufweist, die eine wannenförmige Vertiefung enthält, welche einen Aufnahmeraum für eine Steuerelektronik bildet. Eine flexible Leiterplatte ist in einem die Vertiefung umlaufenden Bereich dicht mit der Trägerplatte verklebt und über einen Rand der Vertiefung in diese hineingeführt. Eine Kunststofffolie oder dünne Platte ist über eine Verklebung mit der flexiblen Leiterplatte an der Trägerplatte befestigt und verschließt dabei die Vertiefung dicht.

Hiervon ausgehend liegt der vorliegenden Erfindung die Aufgabe zugrunde, Maßnahmen anzugeben, welche insb. in mechatronischen Steuervorrichtungen zunächst eine deutliche Flächenreduzierung des teuren Flex-Materials gestatten. Darüber hinaus sind Maßnahmen anzugeben, welche eine vergleichbare Dichtigkeit gewährleisten.

Diese Aufgabe wird erfindungsgemäß durch die Merkmale des unabhängigen Patentanspruchs gelöst. Vorteilhafte Ausgestaltungen und Weiterbildungen, welche einzeln oder in Kombination miteinander eingesetzt werden können, sind Gegenstand der abhängigen Ansprüche.

Die Erfindung baut auf gattungsgemäßen Steuervorrichtungen dadurch auf, dass als Leiterbahnträger wenigstens eine den Schaltungsträger allenfalls teilweise, also nicht vollständig, umlaufende Teil-Flex-Leiterplatte vorgesehen ist; wobei erfindungsgemäß bevorzugt zwei bis n, insbesondere vier, Teil-Flex-Leiterplatten vorgesehen sind.

Um auch die Stanzkanten der Teil-Flex-Leiterplatten mit Hilfe von Formdichtungen analog dem eingangs beschriebenen, vielfach erprobten Dichtkonzept über die Lebensdauer einer Steuervorrichtung abdichten zu können, sind nachfolgend verschiedene vorteilhafte Ausgestaltungen und Weiterbildungen angegeben.

So wird vorgeschlagen, dass im Randbereich der Teil-Flex-Leiterplatte/n ein sanfter Abfall, vorzugsweise bis zum Niveau der Grundplatte, ausgebildet ist, so dass der verbleibende Übergang mit einem Formdichtelement dauerhaft abgedichtet werden kann. Die Ausbildung des Randabfalls kann beispielsweise mittels eines Prägewerkzeuges erfolgen, welches den Randbereich wenigstens bereichsweise dauerhaft verformt, wobei der so entstehende Übergang mit dem Dichtelement vorteilhaft dauerhaft abgedichtet werden kann.

Kumulativ hierzu wird vorgeschlagen, dass in den Randbereichen der Teil-Flex-Leiterplatte/n Klebepunkte, z.B. auf Epoxy-Basis, gesetzt sind, auf welchen das Formdichtelement dichtend aufsetzt.

In einer weiteren Ausgestaltung wird vorgeschlagen, dass in Bereichen zwischen den Teil-Flex-Leiterplatte/n eine Kleberbahn aufgetragen ist, welche ein gleiches Höhenniveau wie die Teil-Flex-Leiterplatte/n ausbildet. So ist vorteilhaft gewährleistet, dass das Formdichtelement wieder in einer Ebene aufliegt. Das Formdichtelement liegt dann eben auf den Teil-Flex-Leiterplatte/n und in den Übergängen auf der/den Kleberbahnen auf. So ist gewährleistet, dass das Formdichtelement wieder in einer Ebene aufliegt. Die gestanzten Randbereiche der Teil-Flex-Leiterplatte/n werden mit der Kleberbahn abgedichtet. Bewährt hat sich, die Kleberbahnen mittels eines Siebdruckverfahrens aufzubringen, so dass vorteilhaft zeitgleich etwaige Fehlstellen an den gestanzten Randbereichen ausgeglichen werden.

In einer weiteren Ausgestaltung wird vorgeschlagen, dass umlaufend eine Kleberraupe gesetzt ist, auf welchen das Formdichtelement aufsetzt. Die Kleberraupe (z.B. Epoxy) dichtet in diesem Fall vorteilhaft alle Schnittstellen zu der/den Teil-Flex-Leiterplatte/n, zur Grundplatte und zu dem Gehäuse gleichzeitig ab.

In einer weiteren Ausgestaltung wird vorgeschlagen, dass in den Bereichen, wo die Teil-Flex-Leiterplatte/n auf der Grundplatte zum liegen kommen, ein sanfter Übergang in der Grundplatte ausgebildet ist. Auch auf diese weise wird vorteilhaft ein gleiches Höhenniveau von Grundplatte und Oberseite der Teil-Flex-Leiterplatte/n erhalten.

Erfindungsgemäß bevorzugt wird nach dem Verkleben der Teil-Flex-Leiterplatte/n mit einem flüssigkeitsbeständigen Kleber auf der Grundplatte ein umlaufendes und geschlossenes Formdichtungsprofil auf die Bauteile, beispielsweise mittels eines Spritzverfahrens, aufgesetzt, welches vorteilhaft alle Unebenheiten und möglichen Öffnungen zwischen der Teil-Flex-Leiterplatte/n und der Grund- bzw. Bodenplatte sicher schließt. Das Gehäuseteil kann zusammen mit dem Formdichtelement auf dem geschlossenen Formdichtungsprofil mittels einer Klebeverbindung aufsetzen. Alternativ oder kumulativ hierzu kann das Gehäuseteil zusammen mit dem Formdichtelement auf dem geschlossenen Formdichtungsprofil, beispielsweise mittels Nieten, mechanisch verspannt aufsetzt. Eine ausschließlich mechanische Verspannung erlaubt vorteilhaft ein späteres zerstörungsfreies Öffnen für etwaige Instandsetzungen oder Recycel-Aufgaben.

Zweckmäßig ist, durch konstruktive Maßnahmen im Gehäuseteil und/oder der grundplatte den Verlauf des Formdichtelementes bezüglich der Dichtwirkung geeignet zu unterstützen. Auch kann eine spezielle Ausgestaltung des Formdichtelementes das Konzept vorteilhaft unterstützen.

Insbesondere wird in einer weiteren Ausgestaltung der Erfindung vorgeschlagen, die Deckfolie bezogen auf die Basisfolie im Randbereich der Teil-Flex-Leiterplatte/n unterhalb des Formdichtelementes dergestalt zurückversetzt auszubilden, dass die Höhe der Stufe an der Flex-Stanzkante sich reduziert.

Die vorliegende Erfindung hat eine erhebliche Kosteneinsparung durch Reduzierung des Flex-Materials (Faktor 2 bis 3) zum Vorteil. Darüber hinaus erlaubt sie bislang nicht gekannte konstruktive Freiheiten in der Gestaltung des Gerätedesigns wie eine variable Anordnung der Flexteile, eine vereinfachte Realisierung von Kreuzungen durch Übereinanderlegen zweier Flexteile und/oder der möglichen Minimierung der Anzahl der Niete bis hin zu deren Entfall. Darüber hinaus ermöglicht die vorliegende Erfindung eine sinnvolle Kombination von Stanzgitter- und Flex-Technologie, insbesondere im Bereich einer Ventilkontaktierung mit Verbindungsbahnen bis hin zum Elektronikraum und dem Einsatz des bewährten Siemens VDO-Laserschweißverfahrens Flex zu Stanzgitter bzw. einer Flex-Folie im Dichtbereich und im Bereich des Steckers und ggf. der Sensoren zum optimalen Toleranzausgleich. Schließlich führt die vorliegende Erfindung zu einer Kosteneinsparung in der Fertigung und Montage, insbesondere bezüglich der Faltprozesse sowie zu einer erhöhten Qualität bei Einsatz weniger, jedoch erprobter verbindungstechnologien wie Bonden, Laserschweißen etc.; einer Reduzierung der Flex-Einkaufspreise, da Einsatz mehrerer möglicher Flex-Lieferanten (geringere Komplexität und Toleranzanforderungen) und verkürzt aufgrund des Wechsels von einem komplexen Flex-Gesamtteil zu einer Kombination mehrerer einfacher Flex-Einzelteile schließlich vorteilhaft die Entwicklungszeiten mechatronischer Steuergeräte, wie sie insbesondere im Getriebe oder Motor eines Kraftfahrzeuges (Kfz) verbaut werden.

Zusätzliche Einzelheiten und weitere Vorteile der Erfindung werden nachfolgend an Hand eines bevorzugten Ausführungsbeispieles in Verbindung mit der beigefügten Zeichnung beschrieben.

### Darin zeigen schematisch:

- Fig. 1: in einer perspektivischen Darstellung den grundsätzlichen Aufbau des Dichtkonzeptes des Elektronikraumes eines Getriebesteuergerätes;
- Fig. 2: den Aufbau nach Fig. 1 in einer Seitenansicht;

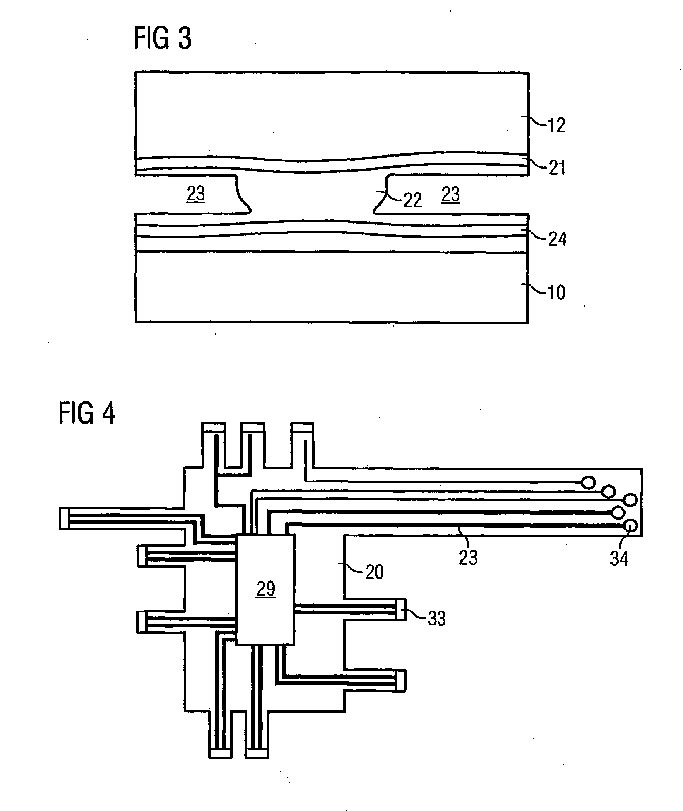

- Fig. 3: den Ausschnitt X aus Fig. 2 in einer vergrößerten Darstellung des Schichtenaufbaus;
- Fig. 4: das Flex-Layout einer mechatronischen Getriebesteuerung;

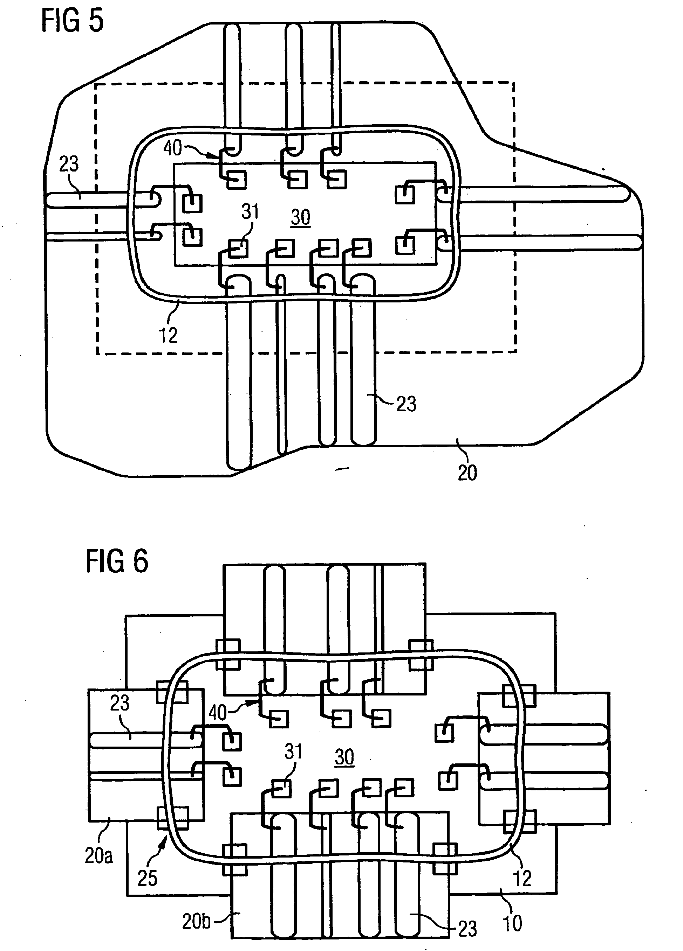

- Fig. 5: den grundsätzlichen Aufbau einer mechatronischen Steuerung bei Verwendung einer einteiligen, einlagigen Flexleiterplatte;
- Fig. 6: den grundsätzlichen Aufbau einer mechatronischen Steuerung bei Verwendung mehrerer erfindungsgemäßer, einlagiger Teil-Flexleiterplatten;

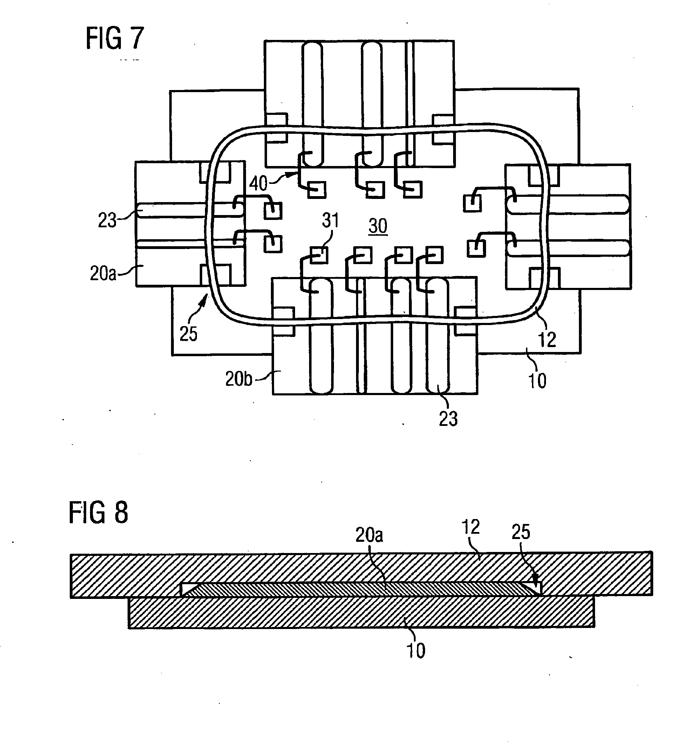

- Fig. 7: das Ausführungsbeispiel nach Fig. 6 mit geprägten Flex-Randbereichen;
- Fig. 8: die geprägten Flex-Randbereiche aus Fig. 7 in einer Seitenansicht;

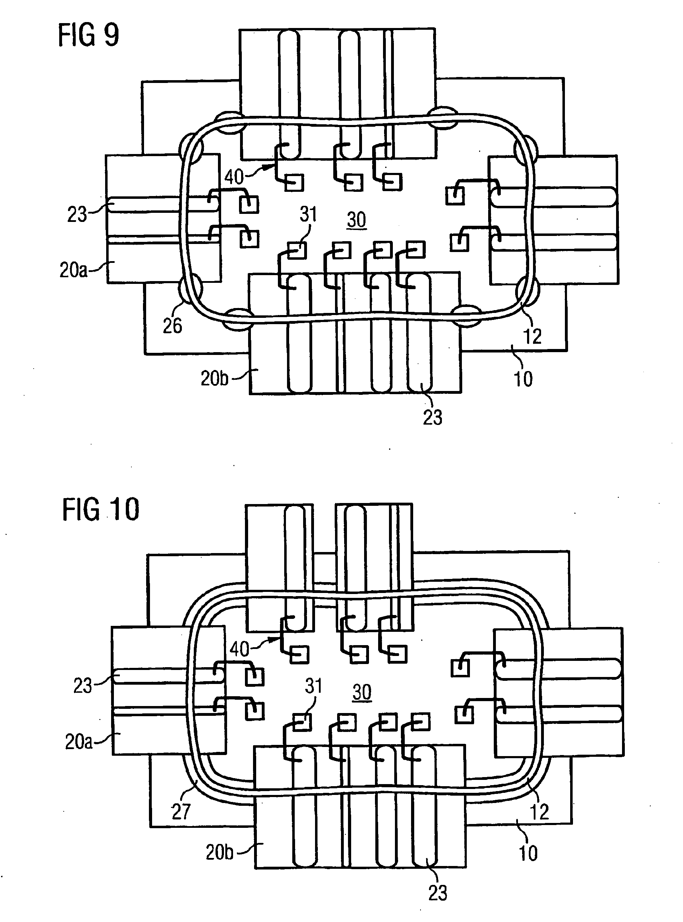

- Fig. 9: das Ausführungsbeispiel nach Fig. 6 mit mittels Klebepunkten verklebten Flex-Randbereichen;
- Fig. 10: das Ausführungsbeispiel nach Fig. 6 mit mittels Ausgleichs-Klebebahnen verklebten Flex-Randbereichen;

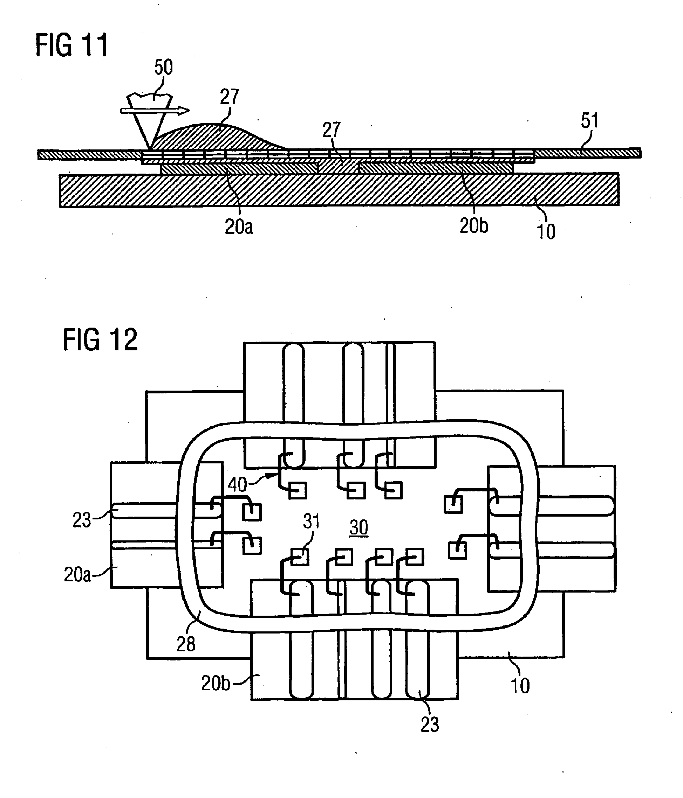

- Fig. 11: die mittels Ausgleichs-Klebebahnen verklebten Flex-Randbereiche aus Fig. 10 in einer Seitenansicht;
- Fig. 12: das Ausführungsbeispiel nach Fig. 6 mit mittels einer Kleberaupe verklebten Flex-Randbereichen;

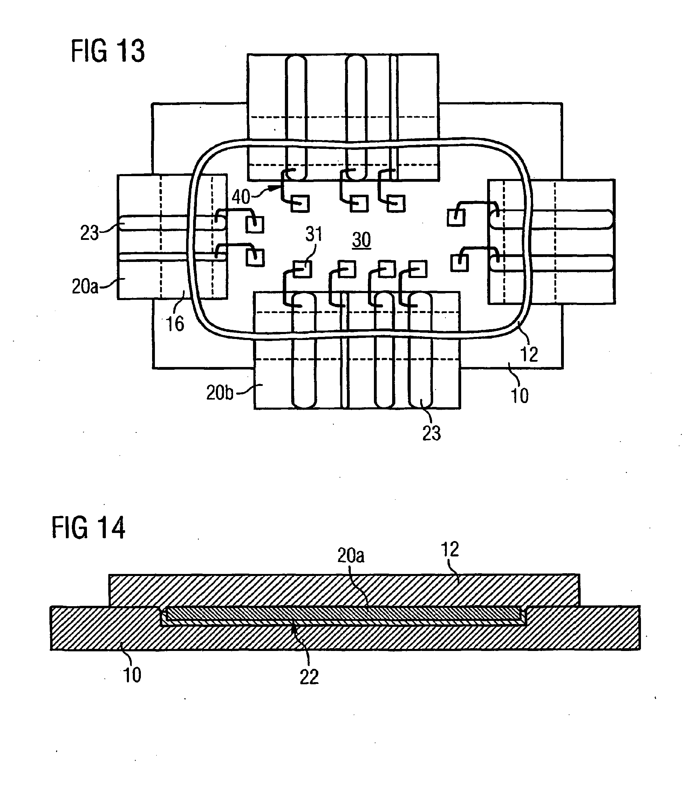

- Fig. 13: das Ausführungsbeispiel nach Fig. 6 mit geprägter Aluminium-Grundplatte;
- Fig. 14: die geprägte Aluminium-Grundplatte aus Fig. 13 in einer Seitenansicht;

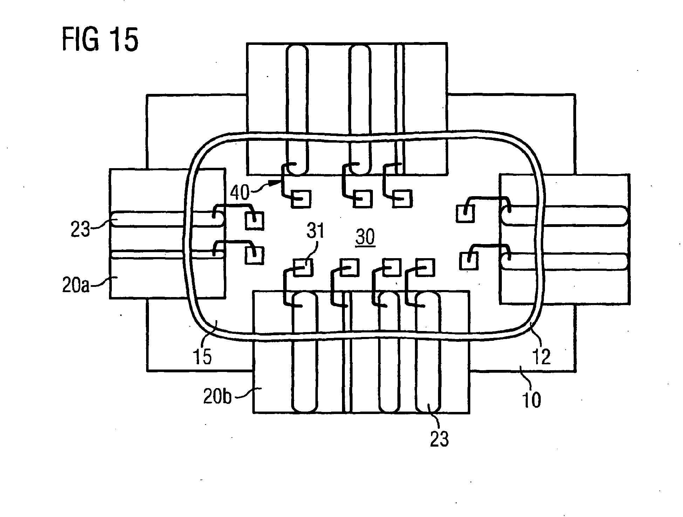

- Fig. 15: das Ausführungsbeispiel nach Fig. 6 mit angespitzter Formdichtung.

Bei der nachfolgenden Beschreibung der bevorzugten Ausführungsformen der vorliegenden Erfindung bezeichnen gleiche Bezugszeichen gleiche oder vergleichbare Komponenten.

Fig. 1 zeigt in einer perspektivischen Darstellung den grundsätzlichen Aufbau des Dichtkonzeptes des Elektronikraumes eines Getriebesteuergerätes.

Fig. 2 zeigt den Aufbau nach Fig. 1 in einer Seitenansicht.

Dargestellt ist die Hälfte eines spiegel- oder rotationssymmetrischen Körpers. Ein Leiterbahnträger 20 ist durch eine Gehäusewand 11 geführt. Genauer ist der Leiterbahnträger 20 zwischen einer metallischen Grundplatte 10 und einem als Gehäusewand 11 ausgebildeten Gehäuseteil in einem Hohlraum 14 geführt. Der Leiterbahnträger 20 ist auf die Grundplatte 10, die vorzugsweise aus Aluminium besteht, mit einem Öl beständigen Acryl-Kleber 22 geklebt. Die Gehäusewand 11 ist Teil eines Gehäusedeckels, welches vorzugsweise ein Kunststoffspritzteil ist. Das Gehäuse 11 besteht lediglich aus dem Gehäusedeckel und der Grundplatte 10 sowie einem umlaufenden, Öl beständigen Dichtring 12 aus z.B. Fluor-Silikon. Dieser 12 ist auf den Leitungsbahnträger 20 aufgedrückt oder anvulkanisiert und dichtet den Leitungsbahnträger 20 gegenüber der Gehäusewand 11 ab. Neben Klebeverbindungen kommt hierfür auch ein mechanisches Verspannen, beispielsweise mittels Nieten 18, in Betracht (nur in Fig. 1 gezeigt). Das Gehäuse kann allerdings auch aus mehreren oder anders gearteten Teilen bestehen (nicht dargestellt). Ferner muss die Grundplatte 10 nicht zwingend einstückig ausgebildet sein.

Fig. 3 zeigt den Ausschnitt X aus Fig. 2 in einer vergrößerten Darstellung. Der dargestellte Schichtenaufbau eines flexiblen Leiterbahnträger 20 besteht aus einer ersten Basis- 24 und einer zweiten Deckfolie 21 jeweils z.B. aus Polyimid, wobei dazwischen eingebettet sich Leiterbahnen 23 z.B. aus Kupfer (Cu) befinden. Durch Einsatz eines Acryl-Klebers 22 zwischen den Schichten 21 und 24 entsteht eine feste Einheit. Der gleiche Acryl-Kleber 22 kann auch für die Verklebung bzw. Laminierung Basisschicht 24 auf der Grund- bzw. Basisplatte 10 Verwendung finden. Deutlich erkennbar ist auch, wie sich das Formdichtelement 12, im Folgenden auch als kürzer als Formdichtung 12 bezeichnet, an der Deckschicht 21 anschmiegt.

Fig. 4 zeigt das Flex-Layout einer mechatronischen Getriebesteuerung. Zu sehen sind beispielhaft einzelne Leitungen 23, die sternförmig von Sensoren bzw. Aktoren 33 und/oder Stecker 34 zwecks Verbindung z.B. zum Kabelbaum eines Kraftfahrzeuges (nicht dargestellt) zu der Steuerelektronik 30 und darauf angeordneten elektronischen Bauelementen 32 verlaufen. Deutlich Erkennbar ist, wie in der Mitte des Flex-Layouts eine Aussparung 29 vorgesehen ist, in welcher der Schaltungsträger 30 mit der Steuerelektronikschaltung 32 platziert wird.

Fig. 5 zeigt den grundsätzlichen Aufbau einer mechatronischen Steuerung bei Verwendung einer einteiligen, einlagigen Flexleiterplatte 20 in einer Innenansicht im Detail. Zu sehen ist die Steuerelektronik 30, die in einer Aussparung 29 im Innenbereich der Flex-Leiterplatte 20 angeordnet ist. Die Enden der Cu-Bahnen 23 in der Flex-Leiterplatte 20 werden mittels Bondverbindungen 40 über elektrische Kontaktstellen 31 mit der Elektronik 30 verbunden. In dieser Ansicht ist auch die Lage der umlaufenden Formdichtung 12 angedeutet.

Anstelle einer Bondverbindung 40 kann auch die in der US 6,300,566 B1 respektive EP 0 972 318 B1 beschriebene elektrische Verbindungsanordnung vorgesehen sein, auf deren Offenbarung insoweit hiermit vollumfänglich Bezug genommen wird.

Fig. 6 zeigt den grundsätzlichen Aufbau einer mechatronischen Steuerung bei Verwendung mehrerer erfindungsgemäßer, vorzugsweise einlagiger Teil-Flexleiterplatten. Um die Randbereiche 25 der Teil-Flex-Leiterplatten 20a, 20b, im Bereich der Dichtungsauflage 12 einer Abdichtung durch diese 12 zugänglich zu machen, werden nachfolgend geeignete Maßnahmen angegeben:

Fig. 7 zeigt das Ausführungsbeispiel nach Fig. 6 mit sog. geprägten Flex-Randbereichen 25. Diese 25 wurden mittels eines Prägewerkzeuges (nicht dargestellt) dauerhaft dergestalt verformt, so dass sich im Flex-Randbereich 25 ein sanfter Abfall bis zum Aluminium-Niveau der Grundplatte 10 ergibt. Die so ausgebildete Niveau-Angleichung zur Basisplatte 20 erlaubt vorteilhaft eine dauerhafte Abdichtung mittels der Formdichtung 12.

Fig. 8 zeigt die im Dichtbereich angeprägten Randbereiche 25 der Teil-Flex 20a, 20b, ... aus Fig. 7 in einer Seitenansicht, welches vorteilhaft ein formschlüssiges Anlegen der Einlegedichtung 12 auf die angeprägte Kante 25 erlaubt.

Fig. 9 zeigt das Ausführungsbeispiel nach Fig. 6 mit mittels Klebepunkten 26 z.B. auf Epoxy-Basis verklebten Flex-Randbereichen 25. Danach wird die Formdichtung 12 aufgesetzt.

Fig. 10 zeigt das Ausführungsbeispiel nach Fig. 6 mit mittels Ausgleichs-Klebebahnen 27 verklebten Flex-Randbereichen 25. In dem Bogen oder geradem Teilstück zwischen zwei Flexteilen 20a, 20b wird eine oder mehrere Kleberbahn/en 27 aufgetragen, bis das gleiche Höhenniveau wie die Flex 20a, 20b, ... erreicht ist. Die Formdichtung 12 liegt dann eben auf den Flexteilen 20a, 20b, ... und in den Übergängen auf den Kleberbahnen 27 auf. So ist gewährleistet, dass die Formdichtung 12 wieder in einer Ebene aufliegt. Die Flexstanzkanten 25 werden mit dem Kleber 27 abgedichtet.

Fig. 11 zeigt die mittels Ausgleichs-Klebebahnen 27 verklebten Flex-Randbereiche 25 aus Fig. 10 in einer Seitenansicht. Gezeigt ist, wie erfindungsgemäß bevorzugt die Kleberschicht 27 mit einem Siebdruckverfahren aufgebracht wird. Dabei wird ein Kleber 27 mittels eines Siebdruckrackl 50 auf die Teil-Flex-Leiterplatten 20a, 20b, ... und die Bodenplatte 10 dergestalt durch ein Sieb 51 aufgetragen, dass nur definierte Spalte bzw. Teil-Flex-Bereiche mit dem Kleber 27 aufgefüllt werden. Ein Pfeil kennzeichnet die Verfahrrichtung des Rackls 50. Vorteilhaft gleichen mittels eines Siebdruckverfahrens aufgebrachte Klebebahnen 27 zugleich etwaige Fehlstellen an den Flexkanten 25 aus.

Fig. 12 zeigt das Ausführungsbeispiel nach Fig. 6 mit mittels einer Kleberaupe 28 verklebten Flex-Randbereichen 25. Erkennbar ist, wie eine Kleberraupe 28 umlaufend aufgebracht und der Deckel 11 mit der Grundplatte 10 verklebt wird. Der Kleber (z.B. Epoxy) dichtet in diesem Fall alle Schnittstellen zur Flex 20a, 20b, ..., zur Aluplatte 10 und zu dem Kunststoffdeckel 11 gleichzeitig ab. Als Kleber kann auch eine auf Druck- und Temperatur sensible Akrylkleberfolie 22 verwendet werden, welche die Flexteile 20a, 20b, ... selber mit der Bodenplatte 10 öldicht verklebt. In dieser Ausführung kann gegebenenfalls auf eine mechanische Haltemaßnahme (z.B. Niete 18) verzichtet werden.

Fig. 13 zeigt das Ausführungsbeispiel nach Fig. 6 mit geprägter Aluminium-Grundplatte 10 in den Bereichen, wo die Flexteile 20a, 20b, ... zu liegen kommen. Auf diese weise wird das gleiche Höhenniveau der Bodenplatten- 10 und Oberseiten der Teil-Flex-Leiterplatten 20a, 20b, ... erhalten. Die Anprägungsbreite der Bodenplatte 10 hat vorzugsweise gegenüber der Breite des Teil-Flex-leiterplatte 20a, ... etwas Übermaß. Diese so entstandene "Lücke" zwischen Flexteilkante 25 und Anprägungsvertiefung 16 an der Bodenplatte 10 kann beispielsweise durch Kleberüberschuss 22 beim Flexteillaminierprozess ausgefüllt werden oder durch zusätzlich gesetzte Kleberpunkte 26 ausgeglichen werden. Verbleibende Unebenheiten an der nun entstandenen, gegenüber dem Deckel 11 abzudichtenden Oberfläche sind weit geringer als die ursprüngliche Flexteildicke und lassen sich mittels der Formdichtung 12 zuverlässig abdichten.

Fig. 14 zeigt die geprägte Aluminium-Grundplatte 10 aus Fig. 13 in einer Seitenansicht.

Fig. 15 schließlich zeigt das Ausführungsbeispiel nach Fig. 6 mit angespitzter Formdichtung 12. Nach dem Auflaminieren der Flexteilstücke 20a, 20b, .- auf die Bodenplatte 10 wird ein umlaufendes und geschlossenes Formdichtungsprofil 17 auf die Bodenplatte 10 bzw. die Flexteile-Baugruppe 20a, 2b, ... aufgesetz, insbesondere angespritzt. Auf diese Weise werden alle Unebenheiten und mögliche Öffnungen zwischen Teil-Flex-Leiterplatten 20a, 20b, ... und der Bodenplatte 10 sicher geschlossen. Auf dieses nun angespritzte Formdichtungsprofil 17 wird der Dichtdeckel 11 aufgesetzt und beispielsweise mechanisch mit der Bodenplatte mit einer entsprechenden Dichtkraft, beispielsweise mittels Nieten 18, verspannt.

Die vorliegende Erfindung gestattet erstmals vorteilhaft, mehrere einzelne Teil-Flex-Leiterplatten 20a, 20b, .- so anzuordnen, dass die Entflechtung von Signal- und Strompfaden optimal möglich und gleichzeitig der Einsatz teuerer Flex-Flächen 20 auf ein Minimum reduziert ist. Sie hilft somit Flex-Fläche 20 zu sparen und Flex-Einzelteile so auszugestalten, dass eine optimale Nutzenauslastung möglich wird und so kein Verwurf entsteht. Die einzelnen Teil-Flex-Leiterplatten 20a, 20b, .- sind vorzugsweise auf einer Grundplatte 10 aus Aluminium auflaminiert. Die Randbereiche 25 der Teil-Flex-Leiterplatten 20a, 2b, ... sind durch geeignete Maßnahmen so ausgebildet, dass eine sichere Abdichtung mittels einer Formdichtung gewährleistet ist.

Die vorliegende Erfindung eignet sich damit für mechatronische Steuereinheiten, insbesondere für Steuergeräte zum Verbau in einem Getriebe oder Motor eines Kraftfahrzeuges (Kfz).

## Patentansprüche

1. Steuervorrichtung, insb. mechatronisches Getriebe- oder Motorsteuergerät, umfassend
- einen Schaltungsträger (30), welcher mit Leiterbahnen (23) wenigstens eines flexiblen Leiterbahnträgers (20) verbunden ist, sowie
- eine Grundplatte (10), von welcher der Schaltungsträger (30) und der Leiterbahnträger (20) getragen sind; sowie
- einem Gehäuseteil (11), welches einen Hohlraum (14) ausbildet, in welchem der Schaltungsträger (30) angeordnet ist, wobei
- der Leiterbahnträger (20) zwischen der Grundplatte (10) und dem Gehäuseteil (11) hindurch in den Hohlraum (14) geführt ist; und wobei
- der Leiterbahnträger (20) mit einem flüssigkeitsbeständigen Kleber (22) mit der Grundplatte (10) wenigstens teilweise dergestalt verklebt und mit wenigstens einem Formdichtelement (12) gegenüber dem Gehäuseteil (11) abgedichtet ist, dass keine Flüssigkeit in den Hohlraum (14) eindringen kann;
**dadurch gekennzeichnet, dass**
- als Leiterbahnträger (20) wenigstens eine den Schaltungsträger (30) allenfalls teilweise, also nicht vollständig, umlaufende Teil-Flex-Leiterplatte (20a, 20b, ...) vorgesehen ist,
- wobei im Randbereich (25) der Teil-Flex-Leiterplatte/n (20a, 20b, ...)ein sanfter Abfall ausgebildet ist, so dass der verbleibende Übergang mit dem Formdichtelement (12) dauerhaft abgedichtet werden kann.

2. Steuervorrichtung nach Anspruch 1, **dadurch gekennzeichnet, dass** zwei bis n Teil-Flex-Leiterplatten (20a, 20b, ...) vorgesehen sind.

3. Steuervorrichtung nach einem der vorherigen Ansprüche, **dadurch gekennzeichnet, dass** in den Randbereichen (25) der Teil-Flex-Leiterplatte/n (20a, 20b, ...) Klebepunkte (26) gesetzt sind, auf welchen das Formdichtelement (12) aufsetzt.

4. Steuervorrichtung nach einem der vorherigen Ansprüche, **dadurch gekennzeichnet, dass** in dem/den Bereichen (15) zwischen den Teil-Flex-Leiterplatte/n (20a, 20b, ...) eine Kleberbahn (27) aufgetragen ist, welche ein gleiches Höhenniveau wie die Teil-Flex-Leiterplatte/n (20a, 20b, ...) ausbildet.

5. Steuervorrichtung nach einem der vorherigen Ansprüche, **dadurch gekennzeichnet, dass** umlaufend eine Kleberraupe (28) gesetzt ist, auf welchen das Formdichtelement (12) aufsetzt.

6. Steuervorrichtung nach einem der vorherigen Ansprüche, **dadurch gekennzeichnet, dass** in den Bereichen, wo die Teil-Flex-Leiterplatte/n (20a, 20b, ...) auf der Grundplatte (10) zum liegen kommen ein sanfter Übergang (16) in der Grundplatte (10) ausgebildet ist.

7. Steuervorrichtung nach einem der vorherigen Ansprüche, **dadurch gekennzeichnet, dass** nach dem Verkleben der Teil-Flex-Leiterplatte/n (20a, 20b, ...) mit einem flüssigkeitsbeständigen Kleber (22) auf der Grundplatte (10) ein umlaufendes und geschlossenes Formdichtungsprofil auf die Bauteile (10; 20a, 20b, ...) aufgesetzt wird.

8. Steuervorrichtung nach Anspruch 7, **dadurch gekennzeichnet, dass** das Gehäuseteil (11) zusammen mit dem Formdichtelement (12) auf dem geschlossenen Formdichtungsprofil (17) mittels einer Klebeverbindung aufsetzt.

9. Steuervorrichtung nach Anspruch 7 oder 8, **dadurch gekennzeichnet, dass** das Gehäuseteil (11) zusammen mit dem Formdichtelement (12) auf dem geschlossenen Formdichtungsprofil (17), beispielsweise mittels Nieten (18), mechanisch verspannt aufsetzt.

10. Steuervorrichtung nach einem der vorherigen Ansprüche, **dadurch gekennzeichnet, dass** die Deckfolie (21) bezogen auf die Basisfolie (24) im Randbereich (25) der Teil-Flex-Leiterplatte/n (20a, 20b, ...) unterhalb des Formdichtelementes (12) dergestalt zurückversetzt ausgebildet ist, dass die Höhe der Stufe sich reduziert.

## Claims

1. Control apparatus, in particular a mechatronic transmission control device or engine control device, comprising
- a circuit carrier (30) which is connected to conductor paths (23) of at least one flexible conductor path carrier (20), and
- a base plate (10) on which the circuit carrier (30) and the conductor path carrier (20) are mounted, and
- a housing part (11) which forms a cavity (14) in which the circuit carrier (30) is arranged, wherein
- the conductor path carrier (20) is guided between the base plate (10) and the housing part (11) into the cavity (14), and wherein
- the conductor path carrier (20) is adhered at least partly to the base plate (10) by means of a liquid-resistant adhesive (22) and sealed relative to the housing part (11) by means of at least one gasket element (12), such that no liquid can penetrate into the cavity (14),
**characterised in that**
- provision is made for at least one partial flexible circuit board (20a, 20b, ...) which at most partially i.e. not completely surrounds the circuit carrier (30) as a conductor path carrier (20),
- with a smooth slope being formed in the boundary area (25) of the partial flexible circuit board(s) (20a, 20b, ...), such that the remaining transition zone can be permanently sealed by means of the gasket element (12)

2. Control apparatus according to claim 1, **characterised in that** two to n partial flexible circuit boards (20a, 20b, ...) are provided.

3. Control apparatus according to one of the preceding claims, **characterised in that** adhesive dots (26) on which the gasket element (12) is positioned are placed in the boundary areas (25) of the partial flexible circuit board (s) (20a, 20b, ...).

4. Control apparatus according to one of the preceding claims, **characterised in that** an adhesive track (27) is deposited in the area(s) (15) between the partial flexible circuit board(s) (20a, 20b, ...), forming an elevation which is identical to that of the partial flexible circuit board(s) (20a, 20b, ...).

5. Control apparatus according to one of the preceding claims, **characterised in that** an adhesive bead (28), on which the gasket element (12) is positioned, is applied circumferentially.

6. Control apparatus according to one of the preceding claims, **characterised in that** in the areas where the partial flexible circuit board (s) (20a, 20b, ...) rest on the base plate (10), a smooth transition zone (16) is formed in the base plate (10).

7. Control apparatus according to one of the preceding claims, **characterised in that** after the adhesion of the partial flexible circuit board(s) (20a, 20b, ...) by means of a liquid-resistant adhesive (22) on the base plate (10), a circumferential and continuous gasket profile is deposited on the components (10; 20a, 20b, ...).

8. Control apparatus according to claim 7, **characterised in that** the housing part (11) together with the gasket element (12) is located on the continuous gasket profile (17) by means of an adhesive connection.

9. Control apparatus according to claim 7 or 8, **characterised in that** the housing part (11) together with the gasket element (12) is located and mechanically secured onto the continuous gasket profile (17), e.g. by means of rivets (18).

10. Control apparatus according to one of the preceding claims, **characterised in that** the cover film (21) below the gasket element (12) is set back in relation to the base film (24) in the boundary area (25) of the partial flexible circuit board(s) (20a, 20b, ...), thereby reducing the height of the step.

## Revendications

1. Dispositif de commande, en particulier appareil de commande mécatronique pour boîte de vitesses ou pour moteur, comprenant
- un support de circuit (30) qui est relié à des pistes conductrices (23) d' aumoins un support de pistes conductrices flexible (20), ainsi que
- une plaque de base (10) par laquelle le support de circuit (30) et le support de pistes conductrices (20) sont portés ; ainsi qu'
- une partie de boîtier (11) qui forme une cavité (14) dans laquelle le support de circuit (30) est disposé, dans lequel
- le support de pistes conductrices (20) est engagé dans la cavité (14) en passant entre la plaque de base (10) et la partie de boîtier (11) ; et dans lequel
- le support de pistes conductrices (20) est collé au moins partiellement à la plaque de base (10) au moyen d'une colle (22) résistante aux liquides et il est rendu étanche par rapport à la partie de boîtier (11) au moyen d'au moins un élément d'étanchéité de forme (12) de telle sorte qu'aucun liquide ne peut pénétrer dans la cavité (14) ;
**caractérisé en ce que,**
- comme support de pistes conductrices (20), il est prévu au moins une carte de circuit imprimé flexible partielle (20a, 20b, ...) qui entoure tout au plus partiellement, donc pas entièrement, le support de circuit (30),
- et dans lequel une rampe en pente douce est formée dans la région marginale (25) de la ou des cartes de circuit imprimé flexibles partielles (20a, 20b, , ..), de sorte que la partie restante du joint formé avec l'élément d'étanchéité de forme (12) peut être rendue durablement étanche.

2. Dispositif de commande selon la revendication 1, **caractérisé en ce qu'**il est prévu deux à n cartes de circuit imprimé flexibles partielles (20a, 20b ,..).

3. Dispositif de commande selon une des revendications précédentes, **caractérisé en ce que,** dans les régions marginales (25) de la ou des carte (s) de circuit imprimé flexibles partielles (20a, 20b, , ,..) sont posés des points de colle (26) sur lesquels l'élément d'étanchéité de forme (12) est posé.

4. Dispositif de commande selon une des revendications précédentes, **caractérisé en ce que,** dans la région ou les régions (15) entre la ou les cartes de circuit imprimé flexible(s) partielle(s) (20a, 20b, ...), est déposé un trait de colle (27) qui forme un niveau en hauteur égal à celui de la ou des cartes de circuit imprimé flexible(s) partielle(s) (20a, 20b, ...).

5. Dispositif de commande selon une des revendications précédentes, **caractérisé en ce que,** sur tout le tour, est posé un cordon de colle (28) sur lequel l'élément d'étanchéité de forme (12) est posé.

6. Dispositif de commande selon une des revendications précédentes, **caractérisé en ce qu'**un raccordement en pente douce (16) est formé dans la plaque de base (10), dans les régions où la ou les carte(s) de circuit imprimé flexible(s) partielle(s) (20a, 20b, ...) vient ou viennent, reposer sur la plaque de base (10).

7. Dispositif de commande selon une des revendications précédentes, **caractérisé en ce que,** après le collage de la ou des carte(s) de circuit imprimé flexible(s) partielle(s) (20a, 20b, ...) sur la plaque de base (10) au moyen d'une colle résistante aux liquides (22), un profilé d'étanchéité de forme périphérique et fermé est posé sur les composants (10 ; 20a, 20b, ...).

8. Dispositif de commande selon la revendication 7, **caractérisé en ce que** la partie de boîtier (11), avec l'élément d'étanchéité de forme (12), est appliquée sur le profilé d'étanchéité de forme (17) au moyen d'un assemblage collé.

9. Dispositif de commande selon la revendication 7 ou 8, **caractérisé en ce que** la partie de boîtier (11), avec l'élément d'étanchéité de forme (12), est appliquée sur le profilé d'étanchéité de forme (17) avec précontrainte mécanique, par exemple au moyen de rivets (18).

10. Dispositif de commande selon une des revendications précédentes, **caractérisé en ce que** la pellicule de revêtement (21) est conformée en retrait par rapport à la feuille de base (24) dans la région marginale (25) de la ou des carte(s) de circuit imprimé flexible(s) partielles (20a, 20b, ...), au-dessous de l'élément d'étanchéité de forme (12), de telle sorte que la hauteur de l'épaulement se réduit.
